# EUROPEAN PATENT SPECIFICATION

(11) **EP 0 242 893 B1**
(45) Date of publication and mention of the grant of the patent: **27.01.1993**
(21) Application number: 87200371.0
(22) Date of filing: 02.03.1987
(51) Int. Cl.: H01L 21/60, H01L 21/00

(54) **Method of manufacturing a semiconductor device**
Verfahren zur Herstellung einer Halbleiteranordnung
Procédé pour la fabrication d'un dispositif semi-conducteur

(30) Priority: 26.03.1986 NL 8600769
(43) Date of publication of application: 28.10.1987
(73) Proprietor: Philips Electronics N.V., 5621 BA Eindhoven (NL)
(72) Inventor: Josquin, Wilhelmus J.M.J., NL-5656 AA Eindhoven (NL)
(74) Representative: Houbiers, Ernest Emile Marie Gerlach

(56) References cited:
- EP-A- 0 076 106
- DE-A- 3 023 616
- DE-A- 3 023 616
- IBM TECHNICAL DISCLOSURE BULLETIN, vol. 23, no. 9, February 1981, pages 4135-4136, New York, US; F. BARSON: "Method of contacting shallow emitters"
- IBM TECHNICAL DISCLOSURE BULLETIN, vol. 24, no. 4, September 1981, pages 2157-2159, New York, US; S.P. GAUR et al.: "Performance enhancement of bipolar transistor by emitter depth reduction"
- IBM TECHNICAL DISCLOSURE BULLETIN, vol. 27, no. 2, July 1984, pages 1008-1009, New York, US; J.F. SHEPARD: "Self-aligned bipolar transistor"
- IBM TECHNICAL DISCLOSURE BULLETIN, vol. 25, no. 7B, December 1982, pages 4011-4015, New York, US; C.G. JAMBOTKAR: "Reducing the device size of polysilicon base transistor"
- IBM TECHNICAL DISCLOSURE BULLETIN, vol. 26, no. 1, June 1983, pages 253-255, New York, US; S.G. BARBEE et al.: "Polysilicon base/emitter contact process"
- IBM TECHNICAL DISCLOSURE BULLETIN, vol. 22, no. 9, February 1980, pages 4052-4053, New York, US; F. BARSON: "Modified polysilicon emitter process"

## Description

The invention relates to a method of manufacturing a semiconductor device comprising at least one circuit element, which device has a semiconductor body having a surface, of which a first surface part is occupied by a first electrode zone of the circuit element adjoining this surface, the first electrode zone being of a first conductivity type and a first layer, masking against doping, being present on the surface, in which layer a first opening to be used in a first doping treatment is formed for providing a dopant for a second electrode zone of the circuit element of the second conductivity type in such a manner that, viewed on the surface, the second electrode zone is located entirely within the first electrode zone, while after the first doping treatment a patterned conductive layer for electrical connection of the second electrode zone is provided, which is separated by an insulating layer from the first electrode zone and is located in an opening in this insulating layer on a second surface part of the second electrode zone, the second surface part being of practically the same size as the first opening.

Such a method is known from the European Patent Application laid open to public inspection on April 6^{th} 1983 under number 76 106.

From German patent application laid-open to public inspection under no. 3 023 616, it is known to provide contact openings for the electrical connection of semiconductor zones of circuit elements, in an insulating layer covering these semiconductor zones and then to provide the semiconductor body with a suitably patterned conductive layer. The formation of these contact openings requires a masking layer with a pattern which has to be aligned with respect to the relevant semiconductor zones in such a manner that, for example, the pn junctions formed between adjacent zones remain covered with the insulating layer in any situation. In connection with this alignment, an alignment tolerance is incorporated. For this purpose, a minimum distance between the edge of the contact opening and the edge of the doping opening to be used for providing the relevant semiconductor zone is prescribed for the required masks.

For various reasons, it may be desirable to contact semiconductor zones without the necessity of taking into account the said alignment tolerance. In such cases, the doping opening is often used also as the contact opening. This solution is used, for example, with so-called "washed-out" emitters. In spite of the fact that in these cases treatments at elevated temperature in a oxidizing medium are avoided between the steps of forming the doping opening and providing the conductive layer, the openings have to be cleaned immediately before the step of providing the conductive layer. It is practically inevitable that the edges of the doping openings are then also slightly etched. Especially with the use of semiconductor zones having a small penetration depth, there is a risk that the pn junction limiting the zone to be contacted does not remain sufficiently protected by the insulating layer.

It will be clear that, when a cleaned doping opening is used as a contact opening, the contact opening and hence the surface part of the relevant semiconductor zone covered directly by the conductive layer is at least of the same size as the doping opening and, even if the cleaning operation is carried out with great care, is in fact slightly larger than this doping opening.

The aforementioned European Patent Application published under No. 76 106 indicates another solution, in which the usual alignment tolerance need not be taken into account. For this purpose, a special doping mask is used which is composed of a thin silicon nitride layer masking against oxidation and a polycrystalline silicon layer deposited on it. The doping opening is now provided in the deposited silicon layer and the dopant is implanted in this opening through the silicon nitride layer. Subsequently, the deposited silicon layer is converted entirely into silicon oxide at elevated temperature. In this manner, a silicon oxide layer is obtained which has at the area of the original doping opening an opening which is smaller than the doping opening due to the conversion of the silicon into silicon oxide. Whilst using the silicon oxide layer as a mask, the silicon nitride is then removed from this opening of reduced size, whereupon this opening serves as a contact opening and the conductive layer is provided. The insulating layer is constituted in this case by a double layer consisting of the thin nitride layer located on the semiconductor zone and the silicon oxide layer obtained by conversion.

In the two solutions described, the contact opening is not exactly of the same size as the doping opening, it is true, but the surface part of the relevant semiconductor zone covered by the conductive layer is practically of the same size as the doping opening. The term "practically of the same size" indicates within the scope of the present description that, as far as the contact opening is not identical to the doping opening, this opening is derived at any rate from the doping opening without taking into account the usual alignment tolerance.

For the sake of completeness, it should be noted that the second electrode zone to be contacted may be not only a small emitter zone of a bipolar transistor in an integrated circuit, but, for example, also a gate electrode of a pn junction field effect transistor or an emitter subzone of a power transistor. Such a power transistor may have, for example, an interdigitated structure comprising several strip-shaped emitter zones, in which event, when taking into account the usual alignment tolerance, at least in a direction transverse to the parallel arranged emitter zones this would lead to too large structures, which occupy a large surface area, and/or, for example, have too large an emitter-base capacitance.

The present invention has inter alia for its object to provide a method of manufacturing semiconductor devices comprising semiconductor zones, in which the surface part of the relevant semiconductor zone to be covered by the contacting conductive layer is of practically the same size as the doping opening for this semiconductor zone and which can be used especially also with semiconductor zones having a very small penetration depth, so in structures having pn junctions located at a very small depth below the surface.

The invention is based inter alia on the recognition of the fact that it should be avoided that the ultimate contact opening is larger than the doping opening and further that, after the required dopant has been provided, treatments at elevated temperature, in which diffusion of the dopant may occur, should be limited to a minimum of absolutely required treatments and the introduction of additional treatments of this kind should be avoided as far as possible.

According to the invention, a method of the kind described in the opening paragraph is characterized in that after the first doping treatment a second layer of passivating material is provided at least on a part of the first layer in which the first opening is present, which second layer is removed at least at the area of the first opening by anisotropic etching so that in the first opening an edge portion of the second layer located along the whole edge of the first opening is left, and in that then the patterned conductive layer for electrical connection is provided extending over the first layer and the edge portion into the opening.

The method according to the invention has the advantage that the ultimate contact opening is smaller than the doping opening used without a treatment at elevated temperature being required, in which diffusion of the dopant provided can occur. In most cases, an additional treatment need not even be introduced into the manufacturing process. Moreover, as will be explained below, the method according to the invention is particularly suitable for the manufacture of integrated circuits, in which besides bipolar transistors and/or pn junction field effect transistors also insulated gate field effect transistors are included.

It is noted that from "IBM Technical Disclosure Bulletin, Vol.23, No.9, Feb. 1981, p.4135-4136" it is known per se to provide a contact opening in an insulating layer with an edge portion of silicon oxide along its edge. This document is however not involved with using a same window as a doping opening during a doping treatment for forming a semiconductor zone and as a contact hole for electrical connection of said zone as well. It merely deals with problems of silicide contacts which tend to grow beyond the edge of the contact opening along the interface between the insulating layer and the semiconductor body.

Preferably, as the second layer a layer of insulating material is provided.

In a particular preferred embodiment of the method according to the invention, as the first layer a layer is used which comprises at least a layer of electrically conductive material. This embodiment is of particular importance if also insulated gate field effect transistors are provided in the semiconductor device. In this case, the layer of conductive material is preferably provided simultaneously with an electrically conductive material for a gate electrode of at least one insulated gate field effect transistor. Furthermore, the layer of conductive material advantageously has a pattern with a closed geometry, this pattern surrounding the first opening. The dopant for the second electrode zone can then be provided simultaneously with that for the source and drain zones of the field effect transistor, while no additional processing steps need be introduced into the manufacturing process for providing the pattern surrounding the first opening.

Preferably, as a conductive material a refractory material, such as semiconductor material, titanium, tantalum, molybdenum or tungsten and/or a silicide of these materials is used.

The invention further relates to a semiconductor device manufactured by means of the method according to the invention.

A semiconductor device comprising at least one circuit element, which device has a semiconductor body having a surface adjoined by a first electrode zone of a first conductivity type of the circuit element, the circuit element having a second electrode zone of the second conductivity type which, viewed on the surface, is entirely within the first electrode zone, while a first conductive layer is present, which is separated by an insulating layer from the first electrode zone and which is connected to the second electrode zone through a contact opening in this insulating layer, is preferably characterized in that a second conductive layer is present on the insulating layer, which conductive layer has at the area of the contact opening a first opening corresponding to this contact opening, while at least along the whole edge of the first opening an edge portion of passivating material is provided in this opening, the first conductive layer extending over the second conductive layer and the edge portion into the contact opening.

The invention will be described more fully with reference to a few embodiments and the accompanying diagrammatic drawings, in which:
Figures 1 and 2 show cross-sections of a part of a semiconductor device at different stages of the manufacture,
Fig. 3 is a plan view of this part of the device at the stage shown in Fig. 2, whilst for the sake of clarity the upper layer is omitted,
Figures 4 to 6 show cross-sections at further stages of the manufacture of this semiconductor device,
Figures 7A and 7B show cross-sections of different parts of a second semiconductor device at a first stage of the manufacture,
Figures 8A and 8B are associated plan views of the parts shown in Figures 7A/7B, and
Figures 9A and 9B to 12A and 12B show cross-sections of these parts at further stages of the manufacture.

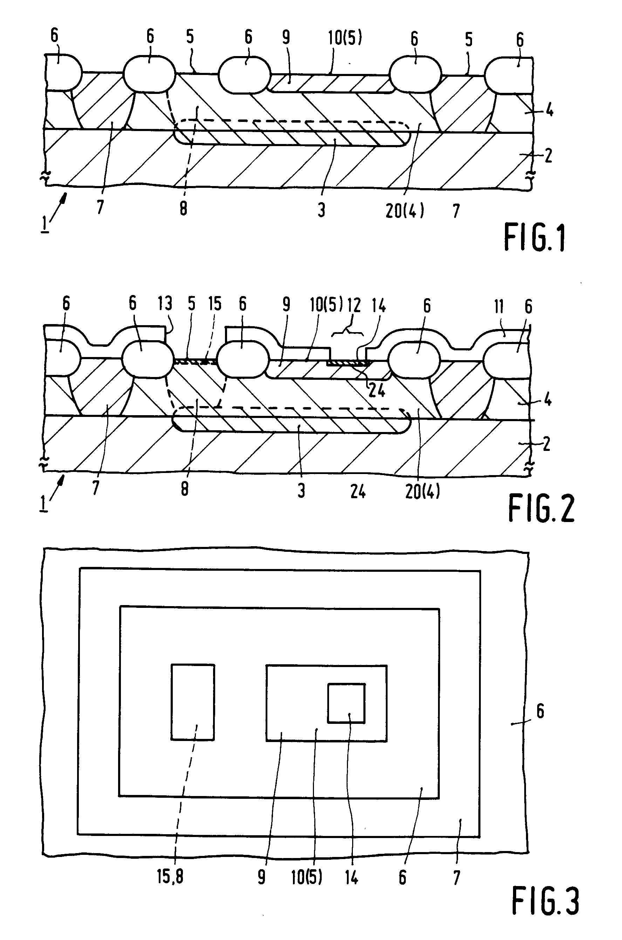

The semiconductor device of the first embodiment in an integrated circuit comprising bipolar transistors, one of which is shown in Figures 1 to 6 at different stages of the manufacture.

Starting from a monocrystalline substrate 2 of, for example, p-type silicon, an n-type dopant for a buried layer 3 is provided in a usual manner, whereupon an n-type epitaxial layer 4 is grown. A layer masking against oxidation, which may comprise, for example, silicon nitride, is provided on the surface 5 of this semiconductor body 1. After this layer has been patterned, the semiconductor body 1 is selectively oxidized, as a result of which a pattern 6 of comparatively thick silicon oxide is obtained, which serves as a field isolation. The thickness of the silicon oxide layer 6 is, for example, about 0.6 µm. In a usual manner, a dopant can be locally provided for the p-type separation zones 7 and a dopant can locally be provided for the n-type deep collector region 8. A treatment at elevated temperature is then carried out, in which these dopants diffuse to a greater depth into the semiconductor body 1. Depending upon the manufacturing process chosen, this treatment may coincide entirely or in part with the oxidation treatment for obtaining the silicon oxide layer 6. The ultimately obtained part 20 (4) of the epitaxial layer 4 isolated from the semiconductor body 1 forms part of the collector zone of the bipolar transistor.

Furthermore, in a usual manner, a dopant can be locally provided for the p-type base zone 9. For example, boron may be implanted at a dose of about 1.10¹⁴ atoms/cm² and an implantation energy of about 30 keV. After the surface 5 has been cleaned, if required, a structure is obtained as shown diagrammatically in Fig. 1. At a next stage of manufacture, al ayer 11 masking against doping (Fig. 2) is present on the surface 5, in which layer openings 12 and 13 are formed for providing a dopant for the emitter zone 14 and a shallow collector contact zone 15. Fig. 3 shows diagrammatically an associated plan view.

At the stage of the manufacture shown in Figures 2 and 3, it is already apparent that the semiconductor device to be manufactured comprises at least one circuit element, which is in this embodiment a bipolar transistor, and that it has a semiconductor body 1 having a surface part 10 (5) is occupied by a first electrode zone 9 of the transistor zone adjoins this surface 5. The electrode zone 9 is of a first conductivity type. A first layer 11 masking against doping is present on the surface 5, in which layer a first opening 12 to be used in a first doping treatment is present for providing a dopant for a second electrode zone 14 of the transistor. The second electrode zone 14 is of the second conductivity type opposite to the first conductivity type and is doped more highly than the first electrode zone 9. Viewed on the surface 5, the second electrode zone 14 is surrounded entirely by the first electrode zone 9, or in other words, the opening 12 is situated entirely within the first surface part 10 (5) and on all sides at a certain distance from the field isolation 6, which forms the boundary of the surface part 10 (5). The first (9) and the second electrode zone (14) adjoin each other whilst forming a pn junction 24 terminating at the surface 5.

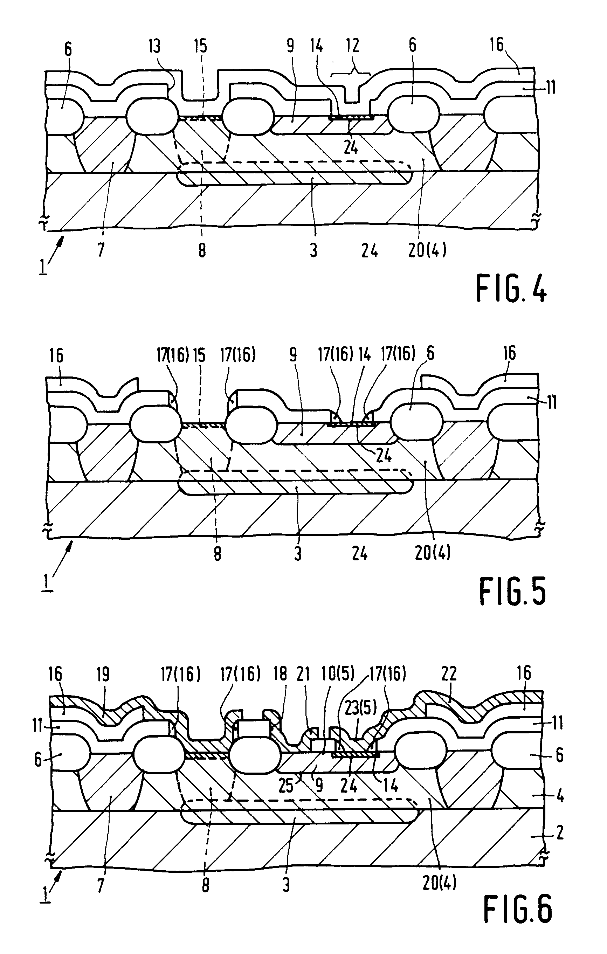

According to the invention, at an instant after the first doping treatment for obtaining the second electrode zone 14 has been carried out, a second layer 16 of passivating material is provided (cf. Fig. 4) at least on a part of the first layer, in which part the first opening 12 is present. Subsequently, this second layer 16 is removed entirely or locally and at least at the area of the first opening 12 by anisotropic etching, for example by means of a usual plasma etching treatment. In the opening 12 and in this embodiment also in the opening 13 an edge portion 17 (16) of the second layer 16 located along the whole edge of each of the openings 12 and 13 is left.

The opening 18 for the electrical connection of the base zone 9 can be provided in a usual manner with the aid of photoresist mask and an etching treatment. If desired, this opening 18 may also be formed already simultaneously with the openings 12 and 13. However, this opening is then covered during the said first doping treatment, in the case of implantation, for example, with a photoresist mask. A suitable dose for this first doping treatment is, for example, about 1.10¹⁶ arsenic atoms per cm².

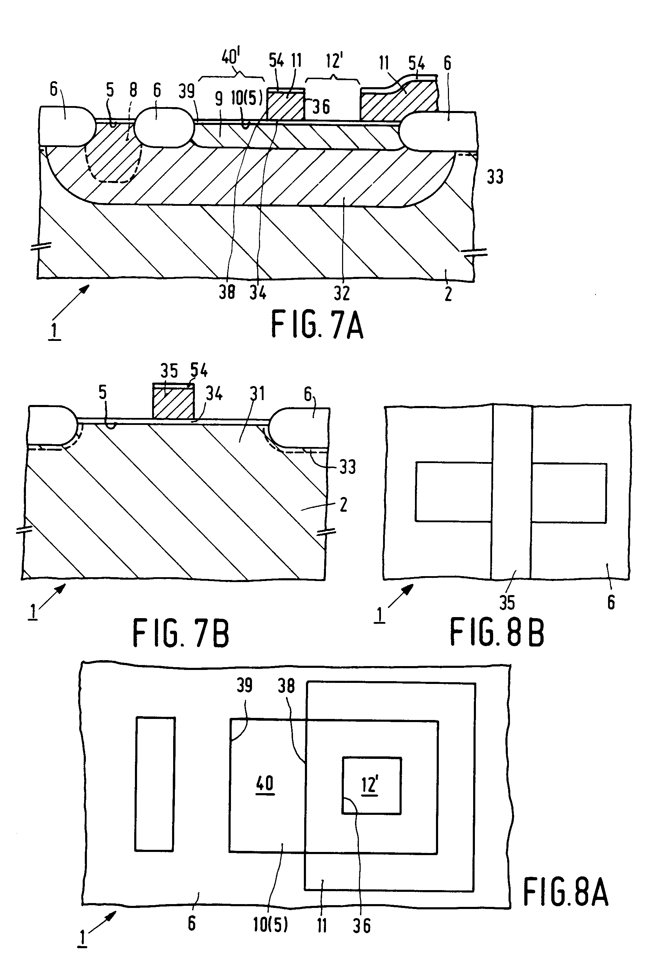

Furthermore, in a usual manner a conductive layer of, for example, aluminium can now be deposited for electrical connection of the collector zone 20 (4), 3,8, the base zone 9 and the second electrode zone (the emitter zone) 14. After this layer has been patterned, the collector zone 20 (4), 3,8 is connected to the conductive layer 19, the base zone 9 is connected to the conductive layer 21 and the emitter zone 14 is connected to the conductive layer 22 (Fig. 6). The conductive layer 22 for electrical connection of the second electrode zone 14 is separated by an insulating layer 11 from the first electrode zone 9 and is located in an opening in this insulating layer 11 derived from the opening 12 on a second surface part 23 (5) of the second electrode zone 14. The second surface part 23 (5) in this case has practically the same size as the first opening 12 because the opening in the layer 11,17 (16) is derived from the doping opening 12 without taking into account the usual alignment tolerance.

The first layer 11 preferably consists of insulating material, such as silicon oxide. A composite first layer 11 may also be used, which consists, for example, of a lower sublayer of silicon oxide and a preferably thin upper sublayer of silicon nitride. If the first layer 11 is a composite layer, the upper sublayer may be of a material different from that of the second layer 16.In this case, the presence of the upper sublayer can facilitate the end point detection during the step of etching the second layer 16. After the second layer 16 has been etched, the upper sublayer may be optionally removed, at least as far as it is exposed after this etching treatment.

The thickness of the first layer 11 is, for example, about 0.5 µm and is preferably not smaller than that about 0.15 µm. By the choice of the thickness of the first layer 11 and the choice of the etching treatment used for forming the opening 12, it can be ensured that the edges of the opening 12 have a suitable shape such that, after the second layer 16 has been etched, edge portions 17 (16) of suitable dimensions are left along the edges of the opening 12. Preferably, the opening 12 is also obtained by means of an anisotropic etching treatment, such as by plasma etching. According as the edges of the opening 12 are steeper and the thickness of the second layer 16 is chosen to be larger, the edge portions 17 (16) obtained will have alarger width and consequently the derived contact opening will be smaller. A suitable thickness for the second layer 16 is, for example, about 0.4 µm. Preferably, this thickness is not smaller than about 0.15 µm. The second layer 16 may be obtained, for example, by deposition of silicon oxide or silicon nitride. After the second layer 16 has been provided, for example, a gettering and at the same time annealing treatment can be carried out for about 60 minutes at a temperature of about 925°C.

For the conductive layers 19, 21 and 22, also materials other than aluminium may be used. For example, these conductive layers may be formed in a usual manner from titanium-tungsten-aluminium, in which event titanium silicide may be formed in the contact openings at the semiconductor surface. Other suitable materials or combinations of materials may be used instead.

The opening 12 has, for example, dimensions of about 2 µm x 2 µm. The dimensions of the surface part 10 (5) occupied by the first electrode zone 9 are then, for example, about 4 µm x 9 µm. The pn junction 24 is located, for example, at a depth of about 0.2 µm below the semiconductor surface 5. The pn junction 24 terminates as a whole at the surface part 10 (5) and is then located on all sides at a certain distance from the field isolation 6, which limits the surface part 10 (5) occupied by the first electrode zone 9. The pn junction 25 between the first electrode zone 9 and the adjoining region 20 (4) is located, for example, at a depth of about 0.3 µm below the surface 5.

The second embodiment is an integrated circuit comprising insulated gate field effect transistors which may have an n-type channel or a p-type channel and one or more bipolar transistors having a vertical structure. For the sake of clarity, the respective Figures 7 to 12 show only a field effect transistor having an n-type channel and a vertical npn transistor, while the diagrammatic Figures are each time subdivided into two associated parts A and B, which show different parts of the same common semiconductor body 1. The part A relates to the bipolar transistor and the part B relates to the field effect transistor.

Figures 7A,B show a semiconductor body 1 which comprises, for example, a p-type silicon substrate or substrate region 2 and is provided in a usual manner with one or more n-type surface regions 32 having a suitably chosen doping concentration profile. The surface regions 32 may be obtained, for example, by means of ion implantation, while, if desired, alternatively first a part of the doping may be provided in a substrate, then a p-type epitaxial layer may be grown and subsequently an additional doping may be provided through the surface 5 of the semiconductor body 1 in the epitaxial layer not shown.

Besides the n-type surface regions 32, the doping concentration profile in p-type surface regions 31 of the substrate may be adapted in a usual manner, for example by implantation, to the circuit elements to be obtained and the desired electrical properties thereof.

The semiconductor body 1 may further be provided in a usual manner with a deep n-type contact zone 8, with a p-type channel stopper zone 33 and with a pattern of field insulation 6. The latter pattern may be obtained, for example, by local oxidstion of the semiconductor body 1. The pattern then consists of silicon oxide. Other conventional forms of field isolation, such as filled grooves, may also be used. The field isolation 6 limits at the surface 5 active regions for the transistors to be formed. For example, the semiconductor body 1 may also comprise one or more n-type surface regions 32 (not shown) for accomodating in a usual manner one or more field effect transistors having an insulated gate and a p-type channel. In surface regions 32 for accomodating field effect transistors, the deep contact zone 8 may be omitted.

In the active regions, the surface 5 is provided with an insulating layer 34 suitable for use as the dielectric layer for the gate electrodes of the field effect transistors. For example, the layer 34 is obtained by thermal oxidation of the semiconductor body 1 and the layer 34 has a thickness of about 25 nm. Subsequently, by means of a photolacquer mask (not shown), a dopant for the p-type base zone 9 (the first electrode zone) is implanted in a part of the surface region 32. A suitable dose is, for example, about 2.10¹³ to 1.10¹⁴ boron atoms per cm². The implantation energy lies, for example, approximately between 30 and 50 keV. The base zone 9 occupies a first part 10 (5) of the surface 5. Subsequently, a conductive layer of, for example, polycrystalline or amorphous silicon or of titanium, tantalum, molybdenum or tungsten is provided. If a silicon layer is used as a conductive layer, this layer may be doped in a usual manner during the deposition or thereafter by means of, for example, PH₃. The thickness of such a silicon layer is, for example, 500 nm. Besides the gate electrode 35, also a pattern 11 of conductive material located above the base zone 9 on the first insulating layer 34 already present is obtained from this layer. The pattern 11 defines the edge 36 of an opening 12' (cf. also Figures 8A.B). The pattern 11 is, for example, annular or has at least a closed geometry, while the edge 36 is located on all sides at a certain distance from the edge pattern of field isolation 6 above the base zone 9.

In the present embodiment, the pattern 11 also defines a part 38 of the edge 38,39 of a further opening 40' located beside the opening 12' also above the first surface part 10 (5). The remaining part 39 of this edge 38,39 practically coincides with a part of the edge of the pattern of field isolation 6.

An insulating layer 54 is further provided on the conductive layer and this insulating layer is then patterned simultaneously with the conductive layer. The gate electrode 35 and the pattern 11 are covered on the upper side with this insulating layer 54. This insulating layer 54 may comprise, for example, silicon oxide or silicon nitride. The insulating layer 54 may also be omitted.

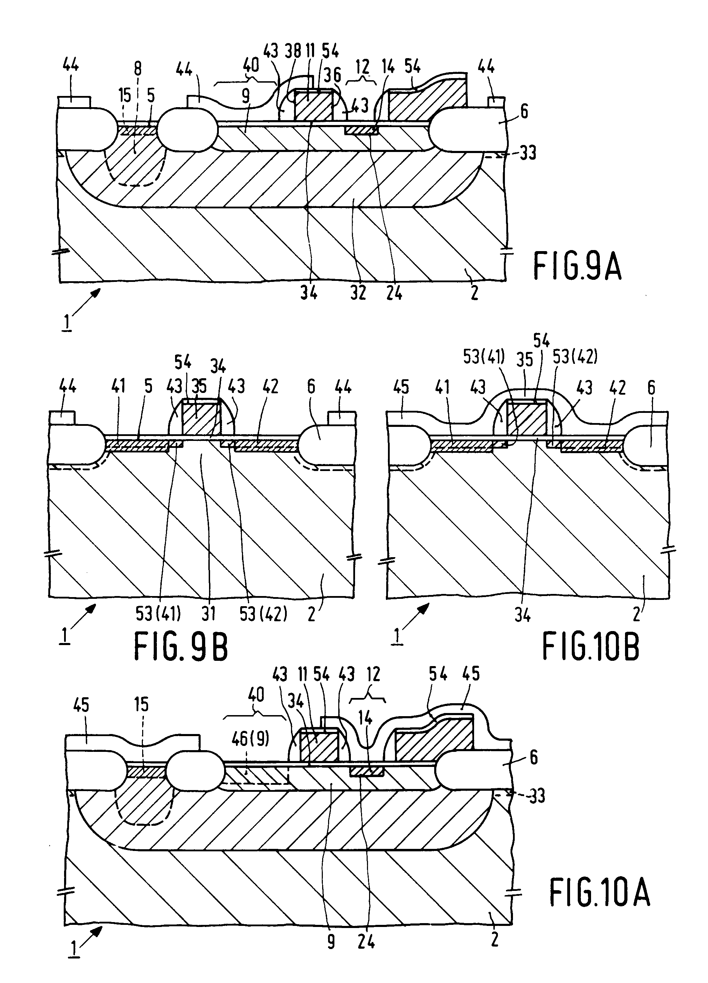

After the gate electrode 35 and the pattern 11 have been obtained, preferably a dopant for source and drain zones 41 and 42 of the field effect transistors is locally provided in the surface region 31 (Fig. 9A,B). For example, phosphorus may be implanted to a dose of about 1.10¹³/cm² and an implantation energy of about 60 keV. This doping treatment serves to provide comparatively weakly doped parts 53 of the source zone 41 and the drain zone 42. During this doping treatment, the part of the surface 5 intended for the source zone 41 may also be screened by means of a masking layer (not shown) so that only the drain zone 42 has a comparatively weakly doped part 53 (42).

Subsequently, an insulating layer of, for example, silicon oxide having a thickness of about 500 nm is deposited on the whole surface of the semiconductor body 1. This insulating layer is removed again in a usual manner by anisotropic etching, edge portions 43 being left along the upright practically vertical edges of the gate electrode 35 and the upright edges 36 and 38 of the pattern 11. As far as the edges of the pattern of field isolation 6, such as the edge 39, are sufficiently steep, edge portions of this insulating layer will be maintained also along these edges. Such edge portions are not shown in the Figures for the sake of simplicity.

As a result of the last described treatment, openings of reduced size 12 and 40 are obtained inter alia at the area of the openings 12' and 40'.

A masking layer 44 is provided on the structure obtained, which layer may consist of, for example, photoresist and covers the opening 40. With the aid of this masking layer 44, a dopant is locally implanted for the source and drain zones 41 and 42 or at least for comparatively highly doped surface parts of these zones 41 and 42. At the same time, the dopant for the emitter zone 14 (the second electrode zone) of the bipolar transistor is implanted. At this stage the dopant for a shallow collector contact zone 15 may also be provided. For example, arsenic ions are implanted at a dose of about 5.10¹⁵/cm² and an implantation energy of about 40 keV. After this treatment, the layer 44 is removed.

By means of a subsequent masking layer 45 (Figures 10A,B), the openings for the source and drain zones 41 and 42 and the opening 12 can now be screened and a doping treatment can be carried out, in which a dopant is provided in the opening 40. For example, BF₂ ions may be used to implant boron. The dose may be about 3.10¹⁵/cm² and the implantation energy is, for example, 65 keV. This doping serves to provide a more highly doped base contact zone 46 (9). During this doping treatment, a dopant for source and drain zones of field effect transistors having a p-type channel further be provided, where required, in the semiconductor body 1. After this doping treatment, the layer 45 is removed. Also in this doping treatment, the pattern 11 provided with edge portions 43 is used as a doping mask, the pattern 11 now defining the edge of the doping opening 40 facing the second electrode zone 14.

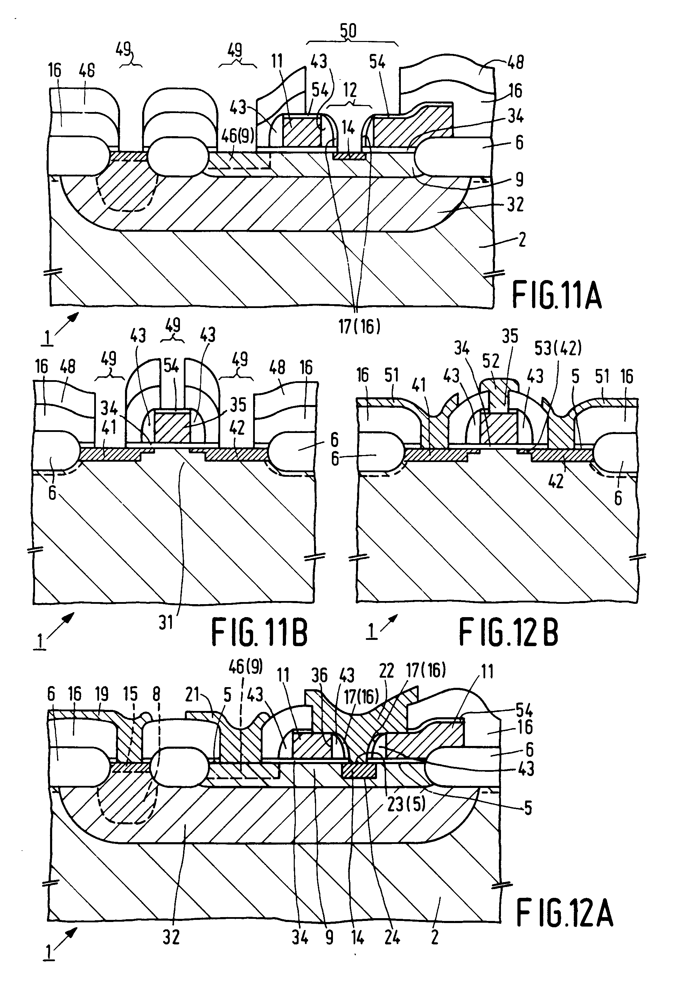

A subsequent treatment consists in providing an insulating layer 16 (Fig. 11A,B). For example, silicon oxide is deposited having a thickness of about 400 nm. The insulating layer 16 cnonstitutes the second insulating layer of the method according to the invention. After the layer 16 has been provided, for example, an annealing treatment may be carried out for about 1 hour at about 925°C. Where required, the dopants provided are activated by this treatment.

A masking layer 48 is provided on the insulating layer 16, which layer may consist, for example, of photoresist and is provided with second openings 49 and 50. Within the scope of the present invention, especially the second opening 50 located above the second electrode zone 14 is of importance. This second opening 50 is positioned so that the edge of the first opening 12 derived from the edge 36 of the pattern 11, i.e. the part of the first opening 12 bounded by the edge portion 43, is located within the second opening 50.

Subsequently, the semiconductor body 1 is subjected to an anisotropic etching treatment, in which openings are formed in the second layer 16 and in which, where required, the parts of the first insulating layer 34 located within the openings 49 and 50 are also removed. Especially the openings 49 located above the gate electrode 35 is indicated diagrammatically. In practical embodiments, this opening 49 will mostly be located not above the channel region of the transistor, but outside the cross-section shown beside the transistor and above the field isolation 6. Within the opening 50, edge portions 17 (16) of the second insulating layer 16 are left along the edge of the first opening 12 after this etching treatment. Preferably, the edge of the opening in the second insulating layer 16 comprising the opening 12 is located wholly above the conductive pattern 11.

In a modification of the method described, during the etching treatment in which the openings 12 and 40 (Fig. 10A,B) are formed, the etching is already continued for such a long time that the parts of the first insulating layer 34 located in these openings 12 and 40 are also removed. The doping treatments following this etching treatment are already described hereinbefore can be carried out in this case with adapted implantation energies.

After the second insulating layer 16 has been etched and the parts of the insulating layer 54 exposed in the openings 49 and 50 have been removed, the masking layer 48 can be removed and a conductive layer of a suitable material, such as aluminium, can be provided. (Fig. 12A,B). In a usual manner, the conductive layer 19 for connection of the collector zone 32,8,15, the conductive layer 21 for connection of the base zone 9,46, the conductive layer 22 for connection of the emiter zone 14, the conductive layers 51 for connection of the source and drain zones 41 and 42 and the conductive layer 52 for connection of the gate electrode 35 can be formed from this conductive layer. The result is inter alia that the conductive layer 22 for connection of the emitrer zone 14 is located on a second surface part 23 (5) of the emitter zone 14, which second surface part 23 (5) extends at the area at which the edge of the first opening 12 derived from the edge 36 is located within the second opening 50 practically to the latter edge. The surface 23 (5) of the emitter zone 14 is practically of the same size as the doping opening 12. The contact opening for the emitter zone 14 is derived from the doping opening 12 without taking into account the usual alignment tolerance.

The use of the method according to the invention renders it possible to utilize very small second electrode or emitter zones 14, which are separated from the electrode or base zone 9 by a pn junction 24 located at a comparatively small depth. The edge portions 17 (16) provided prevent this pn junction 24 located at a small depth from being shortcircuited at the surface 5 by the conductive layer 22.

In the second embodiment, the first layer of the method according to the invention masking against doping comprises the pattern 11 together with the edges 43 and the patterned masking layer 44. If the part of the layer 34 is exposed in the opening 12 is removed before the doping treatment is effected, the insulating layer 34 can also be considered to form part of the first layer. If an insulating layer 54 is provided on the conductive layer from which the pattern 11 is formed and if this top layer is still present on the pattern 11 during the doping treatment, this top layer 54 also forms part of the first layer.

In the embodiments, the circuit element is a vertical bipolar transistor. However, the second electrode zone may also be one of the main electrode zones of a laterally constructed bipolar transistor, the first electrode zone then constituting the control electrode zone (base zone) of this transistor. Especially in the last-mentioned embodiment, the first electrode zone may be a part of an epitaxial layer which, if desired, is isolated from the adjoining part of the semiconductor body. In this case, the first electrode zone has a practically uniform doping concentration, apart from a buried layer, if any.

The circuit element may also be a diode having an anode zone and a cathode zone or a pn junction field effect transistor in which the second electrode zone constitutes, for example, a gate electrode.

The second embodiment results in a semiconductor device comprising at least one circuit element 32,9,14, the device having a semiconductor body 1 provided with a surface 5 adjoined by a first electrode zone 9 of a first conductivity type of the circuit element, the circuit element having a second electrode zone 14 of the second conductivity type which, viewed on the surface 5, is surrounded entirely by the first electrode zone 9, while a first conductive layer 22 is present which is separated by an insulating layer 34 from the first electrode zone 9 and which is connected in a contact opening in this insulating layer 34 to the second electrode zone 14. According to the invention, a second conductive layer 11 (the conductive pattern 11) is present on the insulating layer 34, which second conductive layer has a first opening 12 corresponding to the contact opening at the area of this contact opening, while at least along the whole edge of this first opening 12 an edge portion 17 (16) of passivating material is present, the first conductive layer 22 extending over the second conductive layer 11 and the edge portion 17 (16) into the contact opening.

Preferably, the first conductive layer 22 is separated by an intermediate insulating layer 54 from the second conductive layer 11.

In a further embodiment of this device, the first electrode zone 9 is connected to a further conductive layer 21 and a conductive connection (not shown) is present between the further conductive layer 21 and the second conductive layer 11. In this embodiment, the layer 54 is not removed from the opening 50 and a contact opening (not shown) is provided elsewhere above the conductive layer 11, the conductive layer 11 being connected through this contact opening to a suitably chosen conductor track, in this case to the conductive layer 21. In this embodiment, the capacitance between the conductive pattern 11 and the first electrode zone 9 is shortcircuited.

Advantageously, a second layer 16 of passivating material is present on the second conductive layer 11, this layer of passivating material being provided with a third opening 50, which is larger than the first opening 12, the first opening 12 being entirely located within the third opening 50 and the first conductive layer 22 extending over the second layer 16 of passivating material and being connected in the third opening 50 directly to the second conductive layer 11.

In the second embodiment, the pattern 11 was first provided with edge portions 43 before the doping treatment for the second electrode zone 14 was carried out. However, the pattern 11 may alternatively be used directly and without the edge portions 43 as a doping mask, more particularly if, for example, also in the insulated gate field effect transistor no edge portions 43 are required along the gate electrode 35. If desired, unnecessary edge portions 43 may further also be removed locally by means of a masking and, for example, a wet etching treatment.

In a further modification of the second embodiment, the pattern 11 is used as a doping mask during the doping treatment for obtaining the more weakly doped parts 53 of the field effect transistor and then the edge portions 43 are provided so that the opening 12 is obtained. In this manner, a second electrode zone 14 is obtained, which has a central more highly doped part which is surrounded at the semiconductor surface by an adjoining more weakly doped part of the same conductivity type. In this modification, the protection of the pn junction 24 is in fact ensured by the combination of the edge portions 43 and 17 (16), which now prevent together the conductive layer 22 from overlapping the pn junction 24 at the semiconductor surface. This modification may be used advantageously, for example, if a comparatively high emitter-base breakdown voltage is required, which could otherwise be obtained only with difficulty with a pn junction 24 located at such small depth. The transistor described here having an emitter zone comprising a central more highly doped part surrounded by an adjoining more weakly doped part may also be of advantage when it is obtained in a different manner. However, also in that case the more weakly doped edge of the emitter zone is preferably obtained by means of a doping opening which was reduced in that edge portions were provided, the central part being provided through this opening of reduced size.

Semiconductor materials other than silicon, such as germanium or A^{III}B^{V} compounds, may be used. Furthermore, the conductivity types described may be inverted and other usual dopants may be used. As an insulating material use may also be made, for example, of oxynitride. In a usual manner, several semiconductor devices may be provided simultaneously in a semiconductor wafer, which is then subdivided into separate semiconductor bodies 1. The semiconductor devices may then be finished in a usual manner in a conventional envelope.

## Claims

1. A method of manufacturing a semiconductor device comprising at least one circuit element, this device comprising a semiconductor body (1) having a surface (5), of which a first surface part (10(5)) is occupied by a first electrode zone (9) of the circuit element adjoining this surface (5), the first electrode zone (9) being of a first conductivity type and a first layer (11), masking against doping, being present on the surface (5), in which layer (11) a first opening (12) to be used in a first doping treatment for providing a dopant for a second electrode zone (14) of the circuit element of the second conductivity type is formed in such a manner that the second electrode zone (14), viewed on the surface (5), is located entirely within the first electrode zone (9), while after the first doping treatment a patterned conductive layer (22) for electrical connection of the second electrode zone (14) is provided, which is separated by an insulating layer (11,34) from the first electrode zone (9) and is located in an opening in this insulating layer (11,34) on a second surface part (23(5)) of the second electrode zone (14), the second surface part (23(5)) being practically of the same size as the first opening (12), **characterized in that** after the first doping treatment, at least at the area of the first opening (12), a second layer (16) is provided being of passivating material, which second layer (16) is removed at least at the area of the first opening (12) by anisotropic etching so that within the first opening (12) an edge portion (17(16)) of the second layer (16) located along the whole edge of the first opening (12) is left, and in that then the patterned conductive layer (22) for electrical connection is provided extending over the first layer (11) and the edge portion (17(16)) into the opening.

2. A method as claimed in Claim 1, **characterized in that** as the second layer (16) a layer of insulating material is provided.

3. A method as claimed in Claim 1, **characterized in that** as the first layer (11) a layer is used which comprises at least a layer of electrically conducting material and in that the first layer (11) is separated from the first electrode zone (9) by a dielectric layer (34).

4. A method as claimed in Claim 3, **characterized in that** the layer of electrically conducting material (11) has a pattern surrounding the first opening (12).

5. A method as claimed in Claim 3 or 4, **characterized in that** as the conductive material a refractory material, such as semiconductor material, tantalum titanium, molybdenum or tungsten or a silicide of these materials is used.

6. A method as claimed in Claim 3,4 or 5, **characterized in that** the layer of electrically conducting material (11) is provided simultaneously with an electrically conducting material for a gate electrode (34) of at least one insulated gate field effect transistor.

7. A semiconductor device comprising at least one circuit element, this device comprising a semiconductor body (1) having a surface (5) which is adjoined by a first electrode zone (9) of a first conductivity type of the circuit element, the circuit element having a second electrode zone (14) of the second conductivity type which, viewed on the surface (5), is located entirely within the first electrode zone (9), while a first conductive layer (22) separated by an insulating layer (34) from the first electrode zone (9) is present, which first conductive layer (22) is connected through a contact opening in this insulating layer (34) to the second electrode zone (14), **characterized in that** a second conductive layer (11) is present on the insulating layer (34), which second conductive layer (11) has at the area of the contact opening a first opening (12) corresponding to this contact opening, while at least along the whole edge of this first opening (12) an edge portion (17(16)) of passivating material is present in this first opening (12) and the first conductive layer (22) extends over the second conductive layer (11) and the edge portion (17(16)) into the contact opening.

8. A semiconductor device as claimed in Claim 7, **characterized in that** the first conductive layer (22) is separated by an intermediate insulating layer (54) from the second conductive layer (11).

9. A semiconductor device as claimed in Claim 7, **characterized in that** the first electrode zone (9) is connected to a further conductive layer (21) and a conductive connection is present between this further conductive layer (21) and the second conductive layer (11).

10. A semiconductor device as claimed in Claim 7, **characterized in that** a second layer (16) of passivating material is present on the second conductive layer (11) and is provided with a further opening (50), which is larger than the first opening (12), the first opening (12) being located entirely within the further opening (50) and the first conductive layer (22) extending across the second layer (16) of passivating material and being connected in the further opening (50) directly to the second conductive layer (11).

## Patentansprüche

1. Verfahren zum Herstellen einer Halbleiteranordnung mit mindestens einem Schaltungselement, wobei diese Anordnung einen Halbleiterkörper (1) mit einer Oberfläche (5) aufweist, von der ein erster Oberflächenteil (10(5)) durch eine erste an diese Oberfläche (5) grenzende Elektrodenzone (9) des Schaltungselementes eingenommen wird, wobei die erste Elektrodenzone (9) vom ersten Leitungstyp ist, und wobei auf der Oberfläche (5) eine erste gegen Dotierung maskierende Schicht (11) vorgesehen ist, wobei in dieser Schicht (11) eine bei einer ersten Dotierungsbehandlung zu benutzende erste Öffnung (12) gebildet ist zum Anbringen eines Dotierungsmittels für eine zweite Elektrodenzone (14) des Schaltungselementes vom zweiten Leitungstyp, und zwar derart, daß auf der Oberfläche (5) gesehen die zweite Elektrodenzone (14) völlig innerhalb der ersten Elektrodenzone (9) liegt, während nach der ersten Dotierungsbehandlung eine strukturierte leitende Schicht (22) zur elektrischen Verbindung der zweiten Elektrodenzone (14) vorgesehen wird, die durch eine Isolierschicht (11, 34) von der ersten Elektrodenzone (9) getrennt ist und in einer Öffnung in dieser Isolierschicht (11, 34) auf einem zweiten Oberflächenteil (23(5)) der zweiten Elektrodenzone (14) liegt, wobei dieser zweite Oberflächenteil (23(5)) nahezu dieselbe Größe hat wie die erste Öffnung (12), dadurch gekennzeichnet, daß nach der ersten Dotierungsbehandlung eine zweite Schicht (16) aus Passivierungsmaterial vorgesehen wird, und zwar mindestens im Bereich der ersten Öffnung (12), wobei diese zweite Schicht (16) durch anisotropes Ätzen wenigstens im Bereich der ersten Öffnung (12) derart entfernt wird, daß in der ersten Öffnung (12) ein Randteil (17(16)) der zweiten Schicht (16) längs des ganzen Randes der ersten Öffnung (12) zurückgelassen wird, und daß danach die strukturierte leitende Schicht (22) zur elektrischen Verbindung vorgesehen wird, die sich über die erste Schicht (11) und den Randteil (17(16)) bis in die Öffnung erstreckt.

2. Verfahren nach Anspruch 1, dadurch gekennzeichnet, daß als zweite Schicht (16) eine Schicht aus Isoliermaterial vorgesehen ist.

3. Verfahren nach Anspruch 1, dadurch gekennzeichnet, daß als erste Schicht (11) eine Schicht verwendet wird, die mindestens eine Schicht aus elektrisch leitendem Material aufweist und daß die erste Schicht (11) durch eine dielektrische Schicht (34) von der ersten Elektrodenzone (9) getrennt ist.

4. Verfahren nach Anspruch 3, dadurch gekennzeichnet, daß die Schicht aus elektrisch leitendem material (11) ein die erste Öffnung (12) umgebendes Muster aufweist.

5. Verfahren nach Anspruch 3 oder 4, dadurch gekennzeichnet, daß als leitendes Material ein hitzebeständiges Material, wie Halbleitermaterial, Titan, Tantal, Molybdän oder Wolfram oder ein Silizid dieser Materialien verwendet wird.

6. Verfahren nach Anspruch 3, 4 oder 5, dadurch gekennzeichnet, daß die Schicht aus elektrisch leitendem Material (11) gleichzeitig mit einem elektrisch leitenden Material für eine Gate-Elektrode (34) mindestens eines Feldeffekttransistors mit isolierter Gate-Elektrode vorgesehen wird.

7. Halbleiteranordnung mit mindestens einem Schaltungselement, die einen Halbleiterkörper (1) aufweist mit einer Oberfläche (5), an die eine erste Elektrodenzone (9) eines ersten Leitungstyps des Schaltungselementes grenzt, wobei dieses Schaltungselement eine zweite Elektrodenzone (14) vom zweiten leitungstyp aufweist, die auf der Oberfläche (5) gesehen, völlig innerhalb der ersten Elektrodenzone (9) liegt, und wobei eine durch eine Isolierschicht (34) von der ersten Elektrodenzone (9) getrennte erste leitende Schicht (22) vorgesehen ist, die über eine Kontaktöffnung in dieser Isolierschicht (34) mit der zweiten Elektrodenzone (14) verbunden ist, dadurch gekennzeichnet, daß auf der Isolierschicht (34) eine zweite leitende Schicht (11) vorgesehen ist, die an der Stelle der Kontaktöffnung eine dieser Kontaktöffnung entsprechende erste Öffnung (12) aufweist, wobei wenigstens längs des ganzen Randes der ersten Öffnung (12) in dieser Öffnung (12) ein Randteil (17(16)) aus Passivierungsmaterial vorgesehen ist und wobei die erste leitende Schicht (22) sich über die zweite leitende Schicht (11) und den Randteil (16(17)) bis in die Kontaktöffnung erstreckt.

8. Halbleiteranordnung nach Anspruch 7, dadurch gekennzeichnet, daß die erste leitende Schicht (22) durch eine Zwischenisolierschicht (54) von der zweiten leitenden Schicht (11) getrennt ist.

9. Halbleiteranordnung nach Anspruch 7, dadurch gekennzeichnet, daß die erste Elektrodenzone (9) mit einer weiteren leitenden Schicht (21) verbunden ist und eine leitende Verbindung zwischen dieser weiteren leitenden Schicht (21) und der zweiten leitenden Schicht (11) vorhanden ist.

10. Halbleiteranordnung nach Anspruch 7, dadurch gekennzeichnet, daß eine zweite Schicht (16) aus passivierendem Material auf der zweiten leitenden Schicht (11) vorhanden ist und mit einer weiteren Öffnung (50) versehen ist, die größer ist als die erste Öffnung (12), wobei die erste Öffnung (12) völlig innerhalb der weiteren Öffnung (50) liegt und die erste leitende Schicht (22) sich über die zweite Schicht (16) aus Passivierungsmaterial erstreckt und in der weiteren Öffnung (50) unmittelbar mit der zweiten leitenden Schicht (11) verbunden ist.

## Revendications

1. Procédé de fabrication d'un dispositif semiconducteur comportant au moins un composant, lequel dispositif comporte un corps semiconducteur (1) présentant une surface (5) dont une première partie superficielle (10(5)) est occupée par une première zone d'électrode (9) du composant contigu à cette surface (5), la première zone d'électrode (9) étant d'un premier type de conductivité et une première couche (11), formant un masque contre le dopage, étant située sur la surface (5), couche dans laquelle (11) est formée une première ouverture (12) devant être utilisée dans un premier traitement de dopage pour fournir un dopant pour une deuxième zone d'électrode (14) du composant du deuxième type de conductivité, de mauière que, vue sur la surface (5), la deuxième zone d'électrode (14) est située entièrement dans la première zone d'électrode (9), tandis que, après le premier traitement de dopage, il est prévu une couche conductrice configurée (22) pour la liaison électrique de la deuxième zone d'électrode (14), zone qui est séparée par une couche isolante (11, 34) de la première zone d'électrode (9) et qui est située dans une ouverture pratiquée dans cette couche isolante (11, 34) sur une deuxième partie superficielle (23(5)) de la deuxième zone d'électrode (14), la deuxième partie superficielle (23(5)) présentant pratiquement les mêmes dimensions que la première ouverture (12), caractérisé en ce que, après le premier traitement de dopage, au moins à l'endroit de la première ouverture (12), il est prévu une deuxième couche (16) en matériau de passivation, cette deuxième couche (16) étant enlevée au moins à l'endroit de la première ouverture (12) par décapage anisotropique de façon que, dans la première ouverture (12), il subsiste une partie marginale 17(16)) de la deuxième couche (16) située tout au long du bord de la première ouverture (12), et en ce que, ensuite, la couche conductrice configurée (22) pour la liaison électrique est prévue de façon à ce qu'elle s'étende sur la première couche (11) et sur la partie marginale (17(16)), dans l'ouverture.

2. Procédé selon la revendication 1, caractérisé en ce qu'une couche en matériau isolant (16) est prévue comme deuxième couche.

3. Procédé selon la revendication 1, caractérisé en ce qu'une couche comportant au moins une couche en matériau électriquement conducteur est utilisée comme première couche (11) et en ce que la première couche (11) est séparée de la première zone d'électrode (9) par une couche diélectrique (34).

4. Procédé selon la revendication 3, caractérisé en ce que la couche en matériau électriquement conducteur (11) présente une configuration entourant la première ouverture (12).

5. Procédé selon la revendication 3 ou 4, caractérisé en ce qu'un matériau réfractaire, tel qu'un matériau semiconducteur, du tantale, du titane, du molybdène ou du tungstène ou un siliciure de ces matériaux est utilisé comme matériau conducteur.

6. Procédé selon les revendications 3, 4 ou 5, caractérisé en ce que la couche en matériau électriquement conducteur (11) est prévue en même temps qu'un matériau électriquement conducteur pour une électrode de grille (34) d'au moins un transistor à effet de champ à grille isolée.

7. Dispositif semiconducteur comportant au moins un composant, ce dispositif comportant un corps semiconducteur (1) présentant une surface (5) à laquelle est contiguë une première zone d'électrode (9) d'un premier type de conductivité du composant, le composant présentant une deuxième zone d'électrode (14) du deuxième type de conductivité qui, vue sur la surface (5), est située entièrement dans la première zone d'électrode (9), tandis qu'il y a une première couche conductrice (22) séparée par une couche isolante (34) de la première zone d'électrode (9), cette première couche conductrice (22) étant reliée par l'intermédiaire d'une ouverture de contact pratiquée dans cette couche isolante (34) à la deuxième zone d'électrode (14), caractérisé en ce qu'une deuxième couche conductrice (11) est présente sur la couche isolante (34), cette deuxième couche conductrice (11) présentant à l'endroit de l'ouverture de contact une première ouverture (12) correspondant à cette ouverture de contact, tandis que, au moins tout au long du bord de cette première ouverture (12), une partie marginale (17(16)) en matériau de passivation est présente dans cette première ouverture (12) et que la première couche conductrice (22) s'étend sur la deuxième couche conductrice (11) et sur la partie marginale (17(16)), dans l'ouverture de contact.

8. Dispositif semiconducteur selon la revendication 7, caractérisé en ce que la première couche conductrice (22) est séparée par une couche isolante intermédiaire (54) de la deuxième couche conductrice (11).

9. Dispositif semiconducteur selon la revendication 7, caractérisé en ce que la première zone d'électrode (9) est reliée à une autre couche conductrice (21) et en ce qu'une liaison conductrice est présente entre cette autre couche conductrice (21) et la deuxième couche conductrice (11).

10. Dispositif semiconducteur selon la revendication 7, caractérisé en ce qu'une deuxième couche (16) en matériau de passivation est présente sur la deuxième couche conductrice (11) et est pourvue d'une autre ouverture (50) qui est plus grande que la première ouverture (12), la première ouverture (12) étant située entièrement dans l'autre ouverture (50) et la première couche conductrice (22) s'étendant à travers la deuxième couche (16) en matériau de passivation et étant reliée directement à la deuxième couche conductrice (11) dans l'autre ouverture (50).
